# FASCICULE DE BREVET EUROPEEN

(11) **EP 0 982 859 B1**
(45) Date de publication et mention de la délivrance du brevet: **27.09.2006**
(21) Numéro de dépôt: 99402034.5
(22) Date de dépôt: 10.08.1999
(51) Int. Cl.: H03H 9/64

(54) **Filtre acoustique à deux canaux différents à compensation de réjection**
Akustisches Filter mit zwei verschiedene Kanälen und Sperrkompensation
Acoustic filter with two different channels and rejection compensation

(30) Priorité: 21.08.1998 FR 9810630
(43) Date de publication de la demande: 01.03.2000
(73) Titulaire: Thales, 75008 Paris (FR)
(72) Inventeur: Dufilie, Pierre, 94117 Arcueil Cedex (FR); Chamaly, Stéphane, 94117 Arcueil Cedex (FR)
(74) Mandataire: Esselin, Sophie

(56) Documents cités:
- GB-A- 1 512 790
- US-A- 3 551 837
- US-A- 3 810 257

## Description

La présente invention concerne des filtres à ondes acoustiques de surface pouvant notamment utiliser des transducteurs unidirectionnels de type DART.

Ce type de transducteur présente l'avantage d'émettre ou de recevoir une onde acoustique essentiellement dans une direction ce qui améliore beaucoup le rendement du transducteur. Il se compose d'un ensemble de centres de transduction et de centres de réflexion dont la distribution permet d'obtenir des caractéristiques de filtrage très intéressantes. Toutefois, du fait de leur conception, les DART sont des dispositifs dont la longueur est relativement grande, typiquement plusieurs centaines de λ, si λ est la longueur d'onde à la fréquence centrale de fonctionnement du dispositif. Un filtre similaire est connu par exemple du document GB 1 512 790.

En conséquence, un filtre comportant deux transducteurs de type DART, l'un en entrée, l'autre en sortie nécessite d'utiliser un substrat nettement plus long que large. On est alors conduit à utiliser un boîtier non standard, lui aussi nettement plus long que large, qui s'insère mal dans les systèmes d'implantation habituelle et qui en outre présente des faiblesses en torsion et en flexion.

Dans ce contexte, l'invention propose un filtre à ondes acoustiques de surface utilisant des transducteurs dans lesquels sont intégrés des fonctions de transduction et de réflexion de type DART et comprenant deux canaux reliés électriquement, chaque canal comprenant un transducteur d'entrée et un transducteur de sortie, lesdits canaux ayant des structures optimisées pour permettre d'atteindre des performances en terme de bande de filtrage et de bande de réjection très satisfaisantes en réduisant la longueur du filtre, paramètre qui devient à l'heure actuelle déterminant en terme de coût de filtre.

Plus précisément, l'invention a pour objet un filtre à ondes acoustiques de surface comprenant des transducteurs, chaque transducteur étant défini par une fonction de pondération représentative de la densité de la reflexion et de la transduction à l'intérieur du transducteur ainsi que de la phase des reflexions et des transductions. Cette fonction de pondération peut être réalisée physiquement sur le transducteur soit par une méthode de discrétisation bien connue de l'homme de l'art consistant à choisir dans chaque zones du transducteur, une densité de reflecteurs et une densité de sources, proportionnelles à celles données par la fonction de pondération, soit par une méthode dite de pondération par ouverture consistant à placer dans le transducteur des sources et des réflecteurs sur une ouverture donnée par la fonction de pondération, ledit filtre ayant une bande passante et une bande de réjection données et comportant :
- un premier canal comprenant au moins un premier transducteur d'entrée et un premier transducteur de sortie définissant une première fonction de transfert, ledit premier canal ayant une première fonction résultante de pondération ;
- un second canal comprenant au moins un second transducteur d'entrée et un second transducteur de sortie définissant une seconde fonction de transfert, ledit second canal ayant une seconde fonction résultante de pondération ;
- les premier et second transducteurs d'entrée étant connectés électriquement entre eux ;
- les premier et second transducteurs de sortie étant connectés électriquement entre eux ;
caractérisé en ce que :
- les fréquences centrales des première et seconde fonctions de transfert sont sensiblement égales.
- les fonctions résultantes de pondération des deux canaux sont différentes et telles que les fonctions de transfert du premier canal et du second canal sont en phase dans la bande passante du filtre et en opposition de phase dans la bande de réjection du filtre, la fonction de transfert résultante du filtre est plus étroite et a un meilleur rapport de forme que les fonctions de transfert de chacun des deux canaux.

Avantageusement, les transducteurs d'entrée ou de sortie peuvent être identiques d'un canal à l'autre pour limiter les problèmes de couplage dû à la diffraction entre transducteurs, et qui engendrent généralement l'apparition de lobes secondaires dans la bande de réjection du filtre.

En utilisant des fréquences sensiblement égales pour les fonctions de transfert on obtient un meilleur couplage entre canaux et donc moins de pertes dans le filtre ainsi élaboré.

Selon une variante de l'invention, les transducteurs d'entrée et/ou de sortie sont connectés en série.

Ils comprennent une première série d'électrodes connectées à un bus externe d'une première entrée différentielle (+V), une seconde série d'électrodes connectées à un bus externe d'une seconde entrée différentielle (-V), une troisième série d'électrodes connectées à un bus milieu de potentiel flottant, ladite troisième série séparant lesdites première et seconde série d'électrodes. Le filtre peut également fonctionner en non différentiel le potentiel (+V) peut être remplacé par la masse.

Selon une autre variante de l'invention, les transducteurs d'entrée et/ou de sortie sont connectés en parallèle.

Les transducteurs du premier canal comprennent une première série d'électrodes connectées à un bus externe d'une première entrée différentielle (+V) et une seconde série d'électrodes, les transducteurs du second canal comprennent une troisième série d'électrodes connectées à un bus externe d'une seconde entrée différentielle (-V) et une quatrième série d'électrodes, un sous ensemble d'électrodes de la seconde série d'électrodes étant connecté à un sous-ensemble d'électrodes de la troisième série d'électrodes par l'intermédiaire de pavés de connexions, un sous ensemble d'électrodes de la quatrième série d'électrodes étant connectée à un sous ensemble d'électrodes de la première série d'électrodes par l'intermédiaire de pavés de connexions.

L'invention a aussi pour objet un procédé de réalisation d'un filtre selon l'invention de gabarit donné c'est-à-dire présentant une bande passante et une bande de réjection données.

Ce procédé comprend notamment les étapes suivantes :
- la détermination des fonctions de pondération des transducteurs du premier canal et des transducteurs du second canal, par un processus itératif de manière à définir des fonctions de transfert dudit premier canal et dudit second canal en phase dans la bande passante du filtre et en opposition de phase dans la bande de réjection ;
- une étape de discrétisation des fonctions de pondération préalablement déterminées pour réaliser les masques d'électrodes constitutives de l'ensemble des transducteurs des premier et second canaux.

L'invention sera mieux comprise et d'autres avantages apparaîtront à la lecture de la description qui va suivre donnée à titre non limitatif et grâce aux figures annexées parmi lesquelles :
- la figure 1, schématise un filtre selon l'invention comportant deux canaux comprenant chacun un transducteur d'entrée et un transducteur de sortie ;
- la figure 2, schématise un filtre selon l'invention comprenant en sortie un unique transducteur ;
- la figure 3, illustre les phénomènes de couplage des ondes acoustiques comportant en entrée et en sortie des transducteurs différents ;
- la figure 4, illustre deux transducteurs connectés en série ;
- la figure 5, illustre un transducteur coupé en deux canaux identiques décalés d'une demi-longueur d'onde connectés en série par un bus milieu de potentiel flottant ;
- la figure 6, illustre deux transducteurs différents connectés en série par un bus flottant ;
- la figure 7, illustre deux transducteurs connectés en parallèle;
- la figure 8, illustre deux transducteurs identiques connectés en parallèle et décalés d'une demi-longueur d'onde, selon l'art connu ;
- la figure 9, illustre deux transducteurs différents et connectés en parallèle, utilisés dans un filtre selon l'invention ;
- la figure 10, illustre les fonctions de pondération pour les deux transducteurs, de chacun des canaux utilisés dans un exemple de filtre selon l'invention fonctionnant à 220,38 MHz ;
- la figure 11, illustre la discrétisation des fonctions de pondération ;
- la figure 12, illustre la procédure de détermination de la réponse d'un canal isolé ;
- la figure 13 illustre les amplitudes des fonctions de transfert des deux canaux d'un exemple de filtre selon l'invention fonctionnant à 220,38 MHz, pris isolément ainsi que l'amplitude de la fonction de transfert du filtre résultant.
- la figure 14, illustre les phases des fonctions de transfert des deux canaux d'un exemple de filtre selon l'invention fonctionnant à 220,38 MHz, pris isolément ainsi que l'amplitude et la phase de la fonction de transfert du filtre résultant.

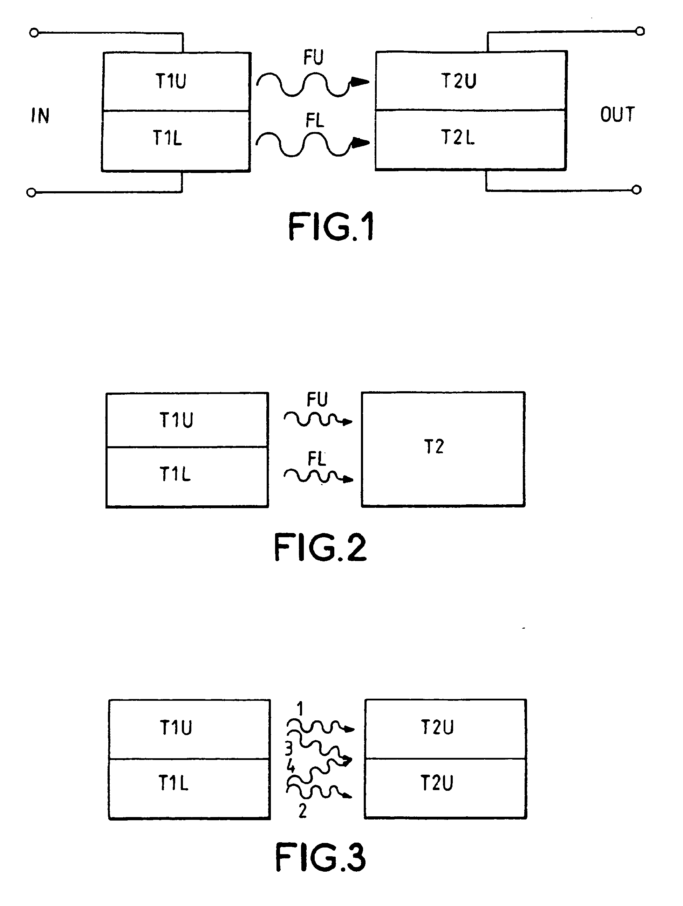

La figure 1 schématise de manière générale le filtre de l'invention. Ce filtre comprend un premier canal dans lequel se propage une onde acoustique FU et comportant au moins un transducteur d'entrée T1U et un transducteur de sortie T2U et un second canal dans lequel se propage une onde acoustique FL et comportant également au moins un transducteur d'entrée T1L et un transducteur de sortie T2L. Les transducteurs d'entrée T1U et T1L sont connectés électriquement à une entrée référencée IN, les transducteurs de sortie T2U et T2L sont connectés à une sortie référencée OUT.

Les deux canaux présentent des fonctions de pondération résultantes différentes mais il peut être avantageux d'utiliser au niveau de l'entrée ou de la sortie deux transducteurs identiques et donc de même fonction de pondération.

Le schéma illustré en figure 2 est ainsi représentatif d'un filtre selon l'invention comprenant deux transducteurs différents d'entrée T1U et T1L et un unique transducteur de sortie T2 équivalent à deux transducteurs identiques.

Une telle structure permet de corriger un inconvénient d'une structure où les canaux sont totalement différents. En effet, comme représenté en figure 3 , il peut exister des couplages entre les canaux à cause de la diffraction. Cela se traduit par l'apparition des ondes acoustiques 3 et 4 différentes des ondes acoustiques 1 et 2. Les amplitudes des ondes 3 et 4 sont faibles mais elles s'ajoutent aux amplitudes des ondes 1 et 2 et peuvent perturber la réjection par une remontée des lobes secondaires.

Dans le cas où l'on a deux transducteurs T2U et T2L identiques, le trajet de l'onde acoustique 3 est identique au trajet de l'onde acoustique 1 à une constante multiplicative prêt. Il en est de même pour les trajets des ondes 2 et 4. L'effet du couplage est très fortement réduit car les trajets des ondes 3 et 4 rajoutent une contribution au filtre, identique à une constante prêt à celle des trajets des ondes 1 et 2.

De manière générale, pour connecter les transducteurs d'entrée T1U et T1L ou les transducteurs de sortie T2U et T2L on peut effectuer des connexions série ou des connexions parallèles. Nous allons décrire ci-après des exemples de méthode permettant ces types de connexions.

### Exemple de connexion en série.

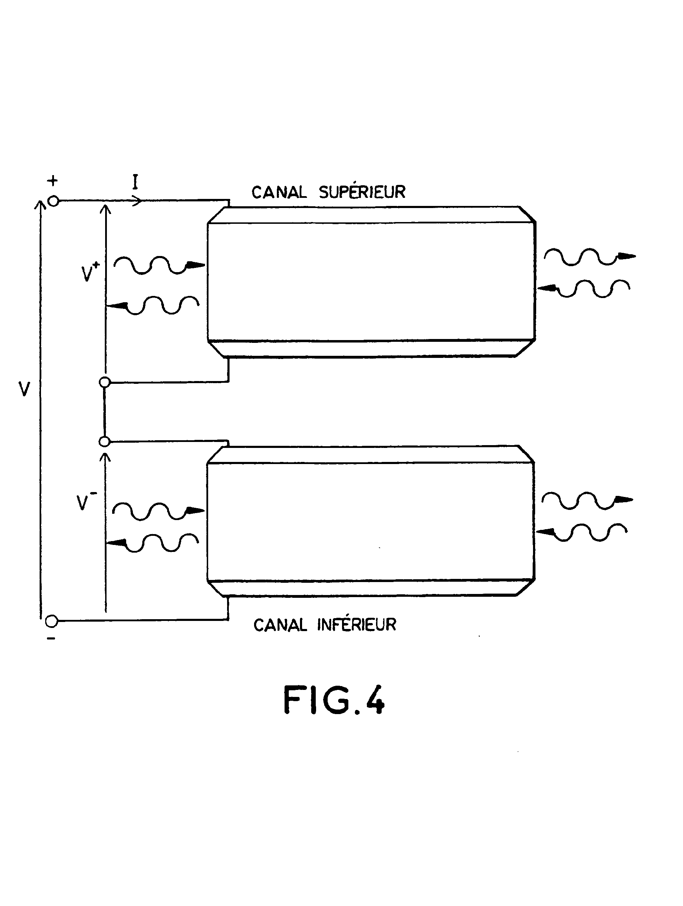

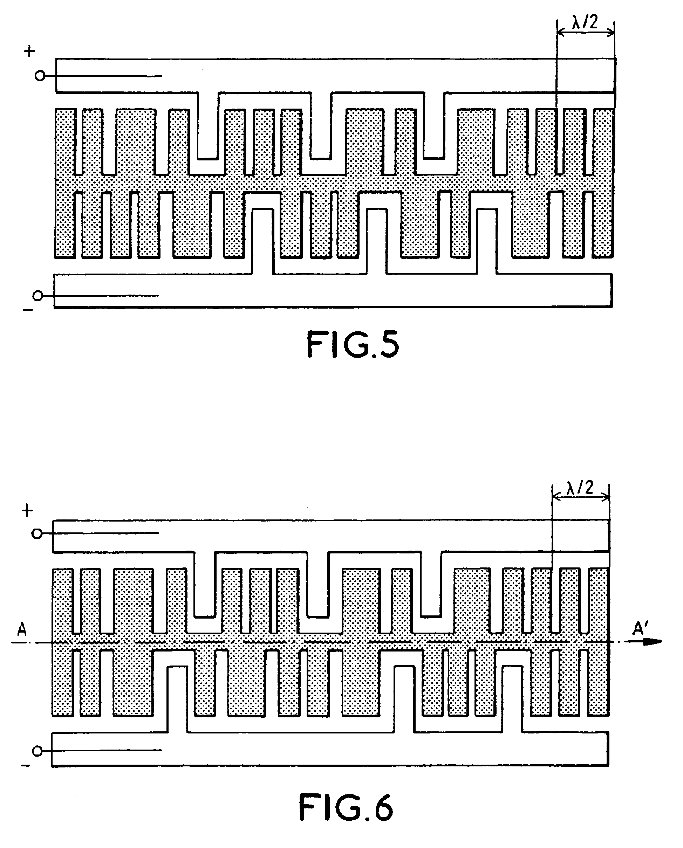

La réalisation physique de la connexion série reprend une méthode connue de réalisation de transducteur piloté en différentiel à deux canaux identiques connectés en série et décrite dans l'article de P. DUFILIE, F.ROUX, M. SOLAL, « Balanced Drive Acoustic Refletion Transducer Structure », IEEE Ultrasonics Symposium Proceedings, 1997, Pages 27-31. Cette méthode permet de transformer un transducteur qui doit être piloté en non différentiel, en différentiel. Pour cela le transducteur est coupé en deux canaux identiques qui sont connectés en série comme illustré figure 4. Les électrodes actives sont connectées aux bus externes référencés + et - et les électrodes restantes sont connectées à un bus milieu de potentiel flottant comme illustré figure 5. Pour générer un mode symétrique, dans ce type de structure, on décale un canal d'une demi-longueur d'onde par rapport à l'autre.

Dans le cadre de l'invention, pour obtenir des canaux de pondérations différentes, on peut reprendre une méthode similaire dans laquelle les électrodes actives sont connectées à deux bus externes et les électrodes restantes sont connectées à un bus central comme l'illustre la figure 6. Les distributions d'électrodes de part et d'autre de l'axe médian AA' étant différentes, on obtient ainsi deux transducteurs différents connectés en série, correspondant aux transducteurs d'entrée ou de sortie utilisés dans un filtre selon l'invention.

### Exemple de connexion en parallèle.

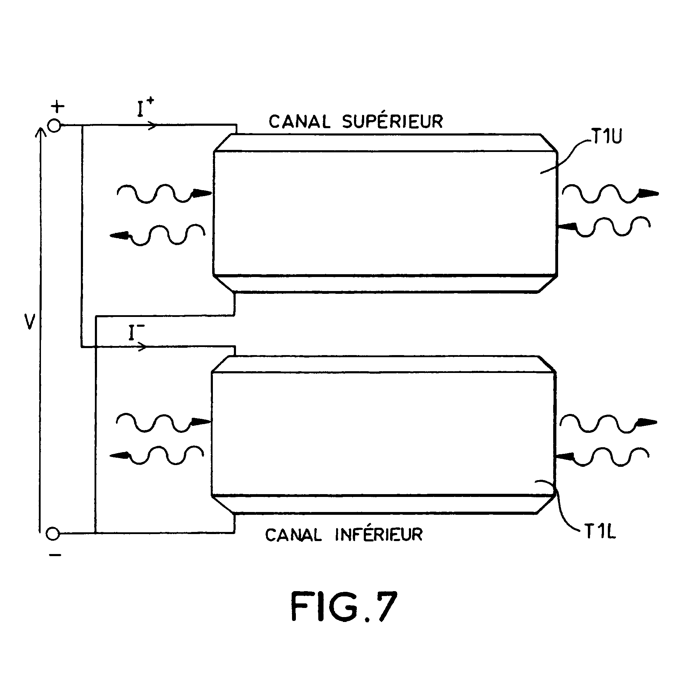

Comme l'illustre la figure 7, de manière schématique les deux transducteurs T1U et T1L sont connectés en parallèle électriquement, les électrodes actives étant connectées à deux bus externes.

Un exemple de connexion en parallèle pouvant être utilisé dans l'invention, reprend une méthode décrite notamment dans la demande de brevet publiée sous le numéro FR 2 740 908 et déposée par la Demanderesse.

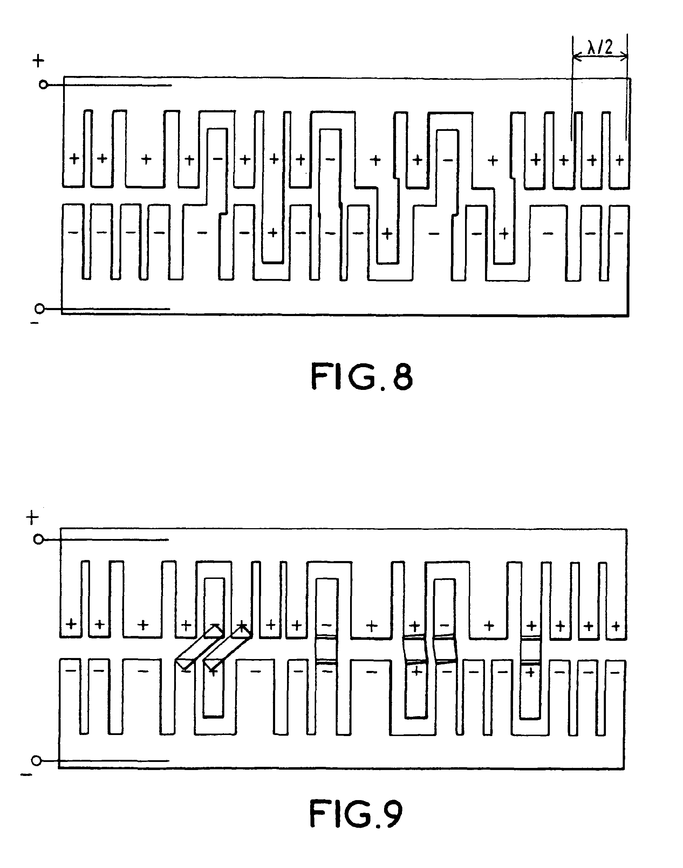

Selon cette méthode, illustrée par la figure 8, on a remplacé la structure comprenant deux transducteurs et quatre bus de connexion par une structure ne comportant plus que deux bus de connexion, le bus connecté au potentiel +V étant en haut et le bus connecté au potentiel -V étant en bas. Dans chacun des canaux, les électrodes sont connectées électriquement à +V ou -V, l'égalité des pondérations et le décalage d'une demi-longueur d'onde entre voies permettant toujours de relier une électrode d'un canal au bus opposé à ce canal par l'intermédiaire d'une électrode du canal opposé relié à ce bus.

Lorsque l'on cherche à obtenir des canaux de pondération différentes, on est amené à réaliser la connexion en parallèle de deux transducteurs différents. Pour les électrodes actives, il faut ramener le potentiel du bus opposé à la manière de la figure 7. Ceci peut être effectué grâce à des pavés de connexion représentés en figure 9 correspondant ainsi exactement aux lignes électriques tracées sur la figure 7 et illustrant les connexions électriques. Un algorithme peut être établi pour effectuer les connexions les plus courtes tout en évitant toute intersection possible. Pour cela la méthode évoquée ci-dessus doit être adaptée. Ainsi pour connecter les électrodes d'un canal au bus opposé à ce canal, on passe par une électrode de l'autre canal relié à ce bus, mais en utilisant un petit pavé d'interconnexion oblique comme illustré en figure 9.

### Exemple d'un filtre selon l'invention pour une application en téléphonie mobile centrée en fréquence à 220,38 MHz.

Il s'agit d'un filtre réalisé sur substrat de quartz dans lequel compte tenu des impédances mises en jeu, on procédera à des connexions en parallèle des transducteurs.

Pour réaliser un tel filtre, on procède dans un premier temps à la détermination des fonctions de pondération de chacun des deux canaux pour obtenir des fonctions de transfert optimisées de manière à satisfaire la caractéristique requise, à savoir de fonctions de transfert en phase dans la bande passantes du filtre et en opposition de phase dans la bande de réjection. Le procédé d'optimisation pouvant être notamment un procédé de type algorithme de Remez décrit dans les articles de P. Ventura, M. Solal, P. Dufilié, J. Desbois, M. Doisy, J.-M. Hodé, « Synthesis of SPUDT Filters with Simultaneous Reflection and Transduction Optimization », IEEE Ultrasonics Symposium Proceedings, 1992, pp 71-75; P. Ventura, M. Solal, P. Dufilié, « S. Chamaly, « A Global Optimization Procedure for SPUDT Filters », IEEE Ultrasonics Symposium Proceedings, 1993, pp 5-8 ; J.-M. Hodé, J. Desbois, P. Dufilié, M. Solal, P. Ventura, « SPUDT-Based Filters : Design Principles and Optimization », IEEE Ultrasonics Symposium Proceedings, 1995, pp 39-50., ou par une méthode décrite par J.Franz et al., « Hybrid optimization techniques for design of SAW filters », 1997 IEEE Ultasonics Symposium pro., pp 33-36

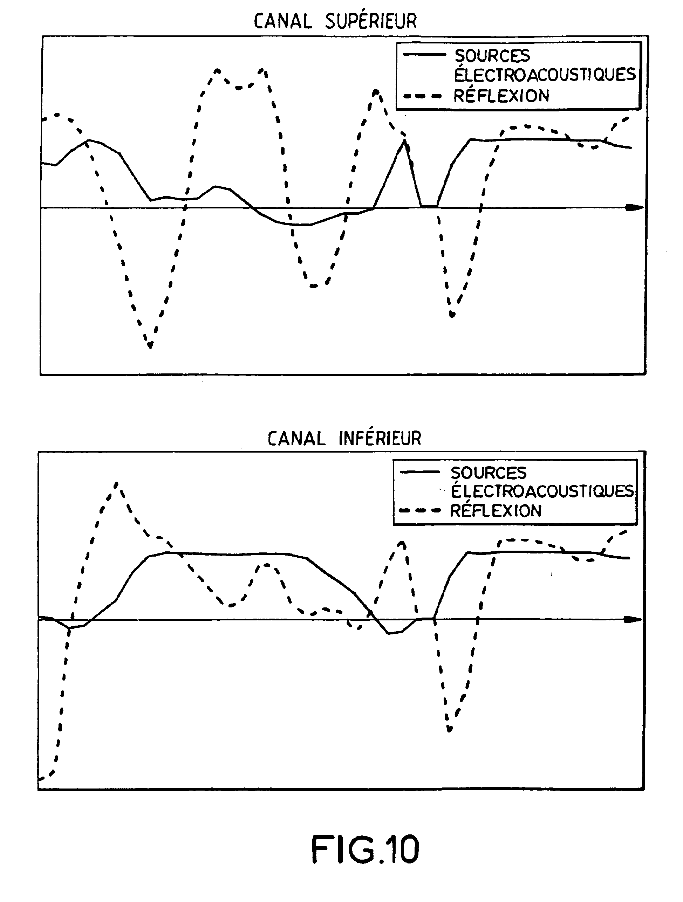

La figure 10 illustre les fonctions de pondération des deux canaux du filtre optimisés correspondant aux fonctions de transmission et de réflexion, le long de l'ensemble des canaux.

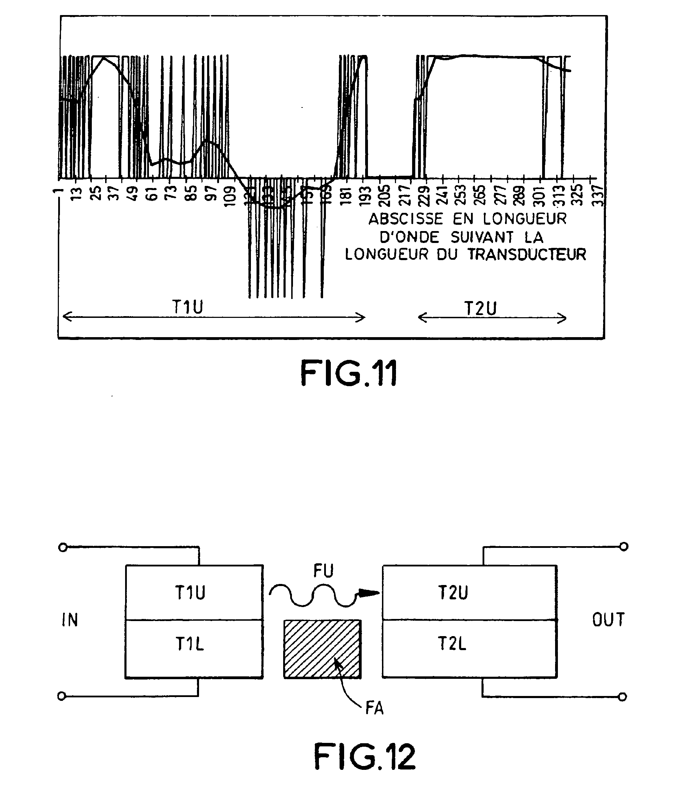

La figure 11 illustre la discrétisation des fonctions de pondération en source des transducteurs T1 U et T2U. On procède de la même manière pour les réflexions et pour le autres transducteurs. Les valeurs que prend la fonction discrète indique le potentiel à appliquer à l'électrode, c'est à dire le bus auquel doit être connectée cette électrode.

La figure 12, illustre une procédure de mise en évidence de la réponse du canal supérieur. Pour ce faire, une forte atténuation acoustique FA est placée sur le trajet des ondes du canal inférieur avant de faire la mesure du filtre. La procédure est identique pour l'autre canal.

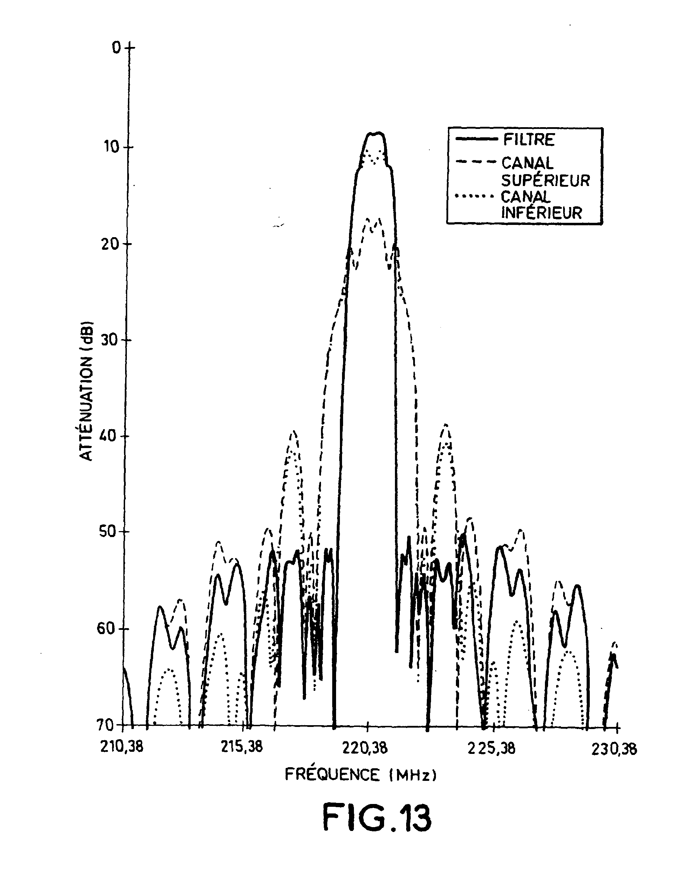

La figure 13, illustre les amplitudes des fonctions de transfert du premier canal et du second canal analysés isolément. Il apparaît que la fonction de transfert résultante du filtre est plus étroite et a un meilleur rapport de forme que les fonctions de transfert de chacun des deux canaux.

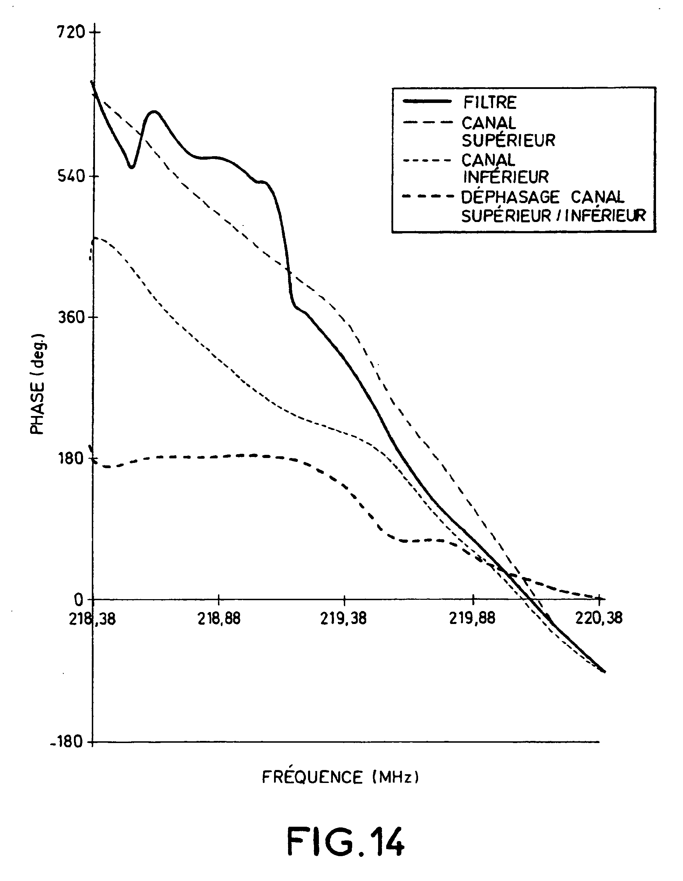

La figure 14, illustre les phases des fonctions de transfert.

L'explication de ce phénomène réside dans les phases des fonctions de transfert des deux canaux. Elles sont en phase à proximité de la fréquence centrale. Les amplitudes s'ajoutent constructivement au niveau de la bande passante.

Elles sont en opposition de phase au niveau de la réjection. Les amplitudes se retranchent, améliorant fortement la réjection et diminuant la bande de réjection du filtre global.

Le fait de réaliser des réponses en fréquence pour chaque canal, avec des bandes plus larges conduit à réduire fortement la taille du filtre tout en gardant une bande de réjection étroite pour la caractéristique globale.

On parvient ainsi à définir un filtre de petite taille nécessitant d'être intégré dans un boîtier de dimensions 7x5 mm², alors que les filtres de l'art antérieur pour ces applications nécessitaient des boîtiers de dimensions 13,3x6,5 mm².

## Revendications

1. Filtre à ondes acoustiques de surface comprenant des transducteurs, chaque transducteur étant défini par une fonction de pondération représentative de la distribution des centres de transduction et des centres de réflexion dudit transducteur, ledit filtre ayant une bande passante et une bande de réjection données et comportant :
- un premier canal comprenant au moins un premier transducteur d'entrée (T1U) et un premier transducteur de sortie (T2U) definissant une première fonction de transfert, ledit premier canal ayant une première fonction résultante de pondération ;
- un second canal comprenant au moins un second transducteur d'entrée (T1L) et un second transducteur de sortie (T2L) définissant une seconde fonction de transfert, ledit second canal ayant une seconde fonction résultante de pondération
- les premier et second transducteurs d'entrée (T1U,T1L) étant connectés électriquement entre eux;
- les premier et second transducteurs de sortie (T2U,T2L) étant connectés électriquement entre eux ;
**caractérisé en ce que** :
- les fréquences centrales des première et seconde fonctions de transfert sont sensiblement égales ;
- les fonctions résultantes de pondération des deux canaux sont différentes et telles que les fonctions de transfert du premier canal et du second canal sont en phase dans la bande passante du filtre et en opposition de phase dans la bande de réjection du filtre,
- la fonction de transfert résultante du filtre est plus étroite et a un meilleur rapport de forme que les fonctions de transfert de chacun des deux canaux.

2. Filtre à ondes acoustiques de surface selon la revendication 1,
**caractérisé en ce que** les premier et second transducteurs d'entrée ou les premier et second transducteurs de sortie possèdent la même fonction de pondération.

3. Filtre à ondes acoustiques de surface selon la revendication 2,
**caractérisé en ce que** les premier et second canaux sont confondus en entrée ou en sortie pour assurer la même fonction de pondération.

4. Filtre à ondes acoustiques de surface selon l'une des revendications 1 à 3, **caractérisé en ce que** les premier et second transducteurs d'entrée et/ou les premier et second transducteurs de sortie sont connectés en série.

5. Filtre à ondes acoustiques de surface selon la revendication 4,
**caractérisé en ce que** les premier et second transducteurs d'entrée et/ou de sortie comprennent une première série d'électrodes connectées à un bus externe d'une première entrée différentielle (+V) ou non, une seconde série d'électrodes connectées à un bus externe d'une seconde entrée différentielle (-V) ou non, une troisième série d'électrodes connectées à un bus milieu de potentiel flottant, ladite troisième série séparant lesdites première et seconde série d'électrodes.

6. Filtre à ondes acoustiques de surface selon l'une des revendications 1 à 3, **caractérisé en ce que** les premier et second transducteurs d'entrée et/ou de sortie sont connectés en parallèle.

7. Filtre à ondes acoustiques de surface selon la revendication 6,
**caractérisé en ce que** les transducteurs du premier canal comprennent une première série d'électrodes connectées à un bus externe d'une première entrée différentielle (+V) ou non et une seconde série d'électrodes, les transducteurs du second canal comprennent une troisième série d'électrodes connectées à un bus externe d'une seconde entrée différentielle (-V) ou non et une quatrième série d'électrodes, un sous ensemble d'électrodes de la seconde série d'électrodes étant connecté à un sous-ensemble d'électrodes de la troisième série d'électrodes par l'intermédiaire de pavés de connexions, un sous ensemble d'électrodes de la quatrième série d'électrodes étant connectée à un sous ensemble d'électrodes de la première série d'électrodes par l'intermédiaire de pavés de connexions.

8. Procédé de réalisation d'un filtre selon l'une des revendications 1 à 7, **caractérisé en ce qu'**il comprend en outre ;
- la détermination des fonctions de pondération des transducteurs du premier canal et des transducteurs du second canal, par un processus itératif de manière à définir des fonctions de transfert dudit premier canal et dudit second canal en phase dans la bande passante du filtre et en opposition de phase dans la bande de réjection ;
- une étape de discrétisation des fonctions de pondération préalablement déterminées pour réaliser les masques d'électrodes constitutives de l'ensemble des transducteurs des premier et second canaux.

## Claims

1. Surface acoustic wave filter comprising transducers, each transducer being defined by a weighting function that is representative of the distribution of the transducing centres and the reflecting centres of the said transducer, the said filter having a given passband and rejection band and comprising:
- a first channel comprising at least a first input transducer (T1U) and a first output transducer (T2U) defining a first transfer function, the said first channel having a first resultant weighting function;
- a second channel comprising at least a second input transducer (T1L) and a second output transducer (T2L) defining a second transfer function, the said second channel having a second resultant weighting function;
- the first and second input transducers (T1U, T1L) being electrically connected together;
- the first and second output transducers (T2U, T2L) being electrically connected together;
**characterized in that**:
- the central frequencies of the first and second transfer functions are substantially equal;
- the resultant weighting functions of the two channels are different and such that the transfer functions of the first channel and of the second channel are in phase within the passband of the filter and out of phase within the rejection band of the filter;
- the resultant transfer function of the filter is narrower and has a better aspect ratio than the transfer functions of either of the two channels.

2. Surface acoustic wave filter according to Claim 1, **characterized in that** the first and second input transducers or the first and second output transducers have the same weighting function.

3. Surface acoustic wave filter according to Claim 2, **characterized in that** the first and second channels share the same input or the same output in order to provide the same weighting function.

4. Surface acoustic wave filter according to one of Claims 1 to 3, **characterized in that** the first and second input transducers and/or the first and second output transducers are connected in series.

5. Surface acoustic wave filter according to Claim 4, **characterized in that** the first and second input and/or output transducers comprise a first series of electrodes connected to an external bus of a first differential input (+V) or not, a second series of electrodes connected to an external bus of a second differential input (-V) or not, and a third series of electrodes connected to a middle bus at floating potential, the said third series separating the said first and second series of electrodes.

6. Surface acoustic wave filter according to one of Claims 1 to 3, **characterized in that** the first and second input and/or output transducers are connected in parallel.

7. Surface acoustic wave filter according to Claim 6, **characterized in that** the transducers of the first channel comprise a first series of electrodes connected to an external bus of a first differential input (+V) or not and a second series of electrodes, the transducers of the second channel comprise a third series of electrodes connected to an external bus of a second differential input (-V) or not and a fourth series of electrodes, a sub-assembly of electrodes of the second series of electrodes being connected to a sub-assembly of electrodes of the third series of electrodes via connecting blocks, a sub-assembly of electrodes of the fourth series of electrodes being connected to a sub-assembly of electrodes of the first series of electrodes via connecting blocks.

8. Process for fabricating a filter according to one of Claims 1 to 7, **characterized in that** it furthermore comprises:
- the determination of the weighting functions of the transducers of the first channel and of the transducers of the second channel by an iterative process in such a way as to define transfer functions of the said first channel and of the said second channel that are in phase within the passband of the filter and out of phase within the rejection band;
- a discretization step for the previously-determined weighting functions in order to produce the masks for the electrodes that make up all of the transducers of the first and second channels.

## Patentansprüche

1. Akustisches Oberflächenwellenfilter, das Transduktoren aufweist, wobei jeder Transduktor durch eine Gewichtungsfunktion definiert wird, die für die Verteilung der Transduktionszentren und der Reflexionszentren des Transduktors repräsentativ ist, wobei das Filter einen gegebenen Durchlassbereich und einen gegebenen Sperrbereich hat und aufweist:
- einen ersten Kanal, der mindestens einen ersten Eingangstransduktor (T1U) und einen ersten Ausgangstransduktor (T2U) aufweist, die eine erste Transferfunktion definieren, wobei der erste Kanal eine erste resultierende Gewichtungsfunktion hat;
- einen zweiten Kanal, der mindestens einen zweiten Eingangstransduktor (T1L) und einen zweiten Ausgangstransduktor (T2L) aufweist, die eine zweite Transferfunktion definieren, wobei der zweite Kanal eine zweite resultierende Gewichtungsfunktion hat;
- der erste und der zweite Eingangstransduktor (T1U, T1L) elektrisch miteinander verbunden sind;
- der erste und der zweite Ausgangstransduktor (T2U, T2L) elektrisch miteinander verbunden sind;
**dadurch gekennzeichnet, dass**:
- die Mittenfrequenzen der ersten und zweiten Transferfunktionen im Wesentlichen gleich sind;
- die resultierenden Gewichtungsfunktionen der beiden Kanäle unterschiedlich und derart sind, dass die Transferfunktionen des ersten und des zweiten Kanals im Durchlassbereich des Filters in Phase und im Sperrbereich des Filters in Gegenphase sind,
- die resultierende Transferfunktion des Filters schmaler ist und ein besseres Formverhältnis hat als die Transferfunktionen jedes der beiden Kanäle.

2. Akustisches Oberflächenwellenfilter nach Anspruch 1, **dadurch gekennzeichnet, dass** der erste und der zweite Eingangstransduktor oder der erste und der zweite Ausgangstransduktor die gleiche Gewichtungsfunktion besitzen.

3. Akustisches Oberflächenwellenfilter nach Anspruch 2, **dadurch gekennzeichnet, dass** der erste und der zweite Kanal am Eingang oder am Ausgang zusammenfallen, um die gleiche Gewichtungsfunktion zu gewährleisten.

4. Akustisches Oberflächenwellenfilter nach einem der Ansprüche 1 bis 3, **dadurch gekennzeichnet, dass** der erste und zweite Eingangstransduktor und/oder der erste und zweite Ausgangstransduktor in Reihe geschaltet sind.

5. Akustisches Oberflächenwellenfilter nach Anspruch 4, **dadurch gekennzeichnet, dass** der erste und der zweite Eingangstransduktor und/oder Ausgangstransduktor eine erste Reihe von Elektroden, die mit einem externen Bus eines ersten differenziellen oder nicht differenziellen Eingangs (+V) verbunden sind, eine zweite Reihe von Elektroden, die mit einem externen Bus eines zweiten differenziellen oder nicht differenziellen Eingangs (-V) verbunden sind, und eine dritte Reihe von Elektroden aufweisen, die mit einem Schwimmpotential-Mittenbus verbunden sind, wobei die dritte Reihe die erste und die zweite Reihe von Elektroden trennt.

6. Akustisches Oberflächenwellenfilter nach einem der Ansprüche 1 bis 3, **dadurch gekennzeichnet, dass** der erste und der zweite Eingangstransduktor und/oder Ausgangstransduktor parallelgeschaltet sind.

7. Akustisches Oberflächenwellenfilter nach Anspruch 6, **dadurch gekennzeichnet, dass** die Transduktoren des ersten Kanals eine erste Reihe von Elektroden, die mit einem externen Bus eines ersten differenziellen oder nicht differenziellen Eingangs (+V) verbunden sind, und eine zweite Reihe von Elektroden aufweisen, die Transduktoren des zweiten Kanals eine dritte Reihe von Elektroden, die mit einem externen Bus eines zweiten differenziellen oder nicht differenziellen Eingangs (-V) verbunden sind, und eine vierte Reihe von Elektroden aufweisen, wobei eine Untereinheit von Elektroden der zweiten Reihe von Elektroden mit einer Untereinheit von Elektroden der dritten Reihe von Elektroden über Blöcke von Verbindungen verbunden ist, wobei eine Untereinheit von Elektroden der vierten Reihe von Elektroden mit einer Untereinheit von Elektroden der ersten Reihe von Elektroden über Blöcke von Verbindungen verbunden ist.

8. Verfahren zur Herstellung eines Filters nach einem der Ansprüche 1 bis 7, **dadurch gekennzeichnet, dass** es weiter aufweist:
- die Bestimmung der Gewichtungsfunktionen der Transduktoren des ersten Kanals und der Transduktoren des zweiten Kanals durch einen iterativen Prozess, um Transferfunktionen des ersten Kanals und des zweiten Kanals in Phase im Durchlassbereich des Filters und in Gegenphase im Sperrbereich zu definieren;
- einen Schritt der Diskretisierung der vorher bestimmten Gewichtungsfunktionen, um die Masken von Elektroden herzustellen, die die Gesamtheit der Transduktoren der ersten und zweiten Kanäle bilden.
